# EUROPÄISCHE PATENTSCHRIFT

(11) **EP 1 989 720 B1**
(45) Veröffentlichungstag und Bekanntmachung des Hinweises auf die Patenterteilung: **31.10.2018**
(21) Anmeldenummer: 07703120.1
(22) Anmeldetag: 30.01.2007
(51) Int. Cl.: H01H 47/00

(54) **SICHERHEITSSCHALTVORRICHTUNG ZUM FEHLERSICHEREN ABSCHALTEN EINES ELEKTRISCHEN VERBRAUCHERS**
SAFETY SWITCHING APPARATUS FOR THE FAILSAFE DISCONNECTION OF AN ELECTRICAL LOAD
DISPOSITIF DE COUPURE DE SECURITE POUR LA COUPURE SANS ERREUR D'UN POSTE DE CONSOMMATION ELECTRIQUE

(30) Priorität: 01.03.2006 DE 102006010106
(43) Veröffentlichungstag der Anmeldung: 12.11.2008
(73) Patentinhaber: Pilz GmbH & Co. KG, 73760 Ostfildern (DE)
(72) Erfinder: NITSCHE, Thomas, 73732 Esslingen (DE); KAUFMANN, Boris, 72631 Aichtal (DE); HOPP, Johannes, 73734 Esslingen (DE); DICKHOFF, Rolf, 73230 Kirchheim (DE)
(74) Vertreter: Witte, Weller & Partner Patentanwälte mbB
(86) Internationale Anmeldenummer: PCT/EP2007/000765
(87) Internationale Veröffentlichungsnummer: WO 2007/101514

(56) Entgegenhaltungen:
- DE-C1- 4 337 665
- DE-C1- 4 423 704

## Beschreibung

Die vorliegende Erfindung betrifft eine Sicherheitsschaltvorrichtung zum fehlersicheren Abschalten eines elektrischen Verbrauchers, insbesondere in einer automatisiert betriebenen Anlage, mit einem ersten und einem zweiten Anschluss zum Zuführen eines ersten und eines zweiten Meldesignals, und mit einem ersten und einem zweiten Schaltelement, die zusammen dazu ausgebildet sind, ein redundantes Ausgangsschaltsignal zum Abschalten des Verbrauchers zu erzeugen, wobei das erste Schaltelement einen ersten Steuerkreis aufweist, dem das erste Meldesignal zugeführt ist, und wobei das zweite Schaltelement einen zweiten Steuerkreis aufweist, dem das zweite Meldesignal zugeführt ist.

Eine solche Sicherheitsschaltvorrichtung ist beispielsweise aus DE 44 23 704 C1 bekannt. Des Weiteren bietet die Anmelderin der vorliegenden Erfindung solche Sicherheitsschaltvorrichtungen unter der Bezeichnung PNOZ® an, beispielsweise in Form des PNOZ X8P.

Sicherheitsschaltvorrichtungen im Sinne der vorliegenden Erfindung dienen dazu, eine gefahrbringende Maschine oder Anlage fehlersicher abzuschalten, wenn dies zum Schutz von Personen erforderlich ist. Die Sicherheitsschaltvorrichtungen überwachen typischerweise Meldesignale, die mit Hilfe von Not-Aus-Tastern, Schutztürschaltern, Lichtschranken, Lichtgittern oder anderen sicherheitsgerichteten Meldegeräten erzeugt werden. Die Sicherheitsschaltvorrichtungen sind in der Lage, in Abhängigkeit von diesen Meldesignalen einen Stromversorgungspfad zu der überwachten Maschine oder Anlage fehlersicher zu unterbrechen.

Abhängig von dem Gefahrenpotential einer Maschine oder Anlage gibt es unterschiedliche Sicherheitskategorien, in denen festgelegt ist, welche Anforderungen eine Sicherheitsschaltvorrichtung für einen bestimmten Einsatzzweck erfüllen muss. Die europäische Norm EN 954-1 definiert beispielsweise vier Sicherheitskategorien, wobei die Kategorie 4 die höchsten Sicherheitsanforderungen an die Eigenfehlersicherheit der Sicherheitsschaltvorrichtung stellt. Vorrichtungen, die die Kategorie 4 erfüllen, sind in der Regel mehrkanalig-redundant aufgebaut. Auch die Meldesignale müssen in einem solchen Fall mehrkanalig-redundant ausgeführt sein, also zumindest ein erstes und ein zweites Meldesignal mit vergleichbarem Informationsgehalt beinhalten.

Des Weiteren erfordert die Kategorie 4, dass ein Querschluss auf den Signalleitungen, die die Meldesignale übertragen, von der Sicherheitsschaltvorrichtung erkannt wird, da durch einen Querschluss die Einfehlersicherheit verloren geht. Für Anwendungen unterhalb der Kategorie 4 kann jedoch auf eine Querschlusserkennung verzichtet werden, was die Verdrahtung der Sicherheitsschaltvorrichtung vereinfacht und die Installation kostengünstiger macht.

Die eingangs genannte Sicherheitsschaltvorrichtung PNOZ X8P kann wahlweise mit und ohne Querschlusserkennung eingesetzt werden, wobei der Anschluss der Signalleitungen zum Zuführen der Meldesignale in den beiden Fällen unterschiedlich ist. Für eine Anwendung mit Querschlusserkennung muss der zweite Kanal des Meldegerätes (das zweite Meldesignal) an andere Anschlussklemmen angeschlossen werden als für eine Anwendung ohne Querschlusserkennung. Um eine flexible Verwendung zu ermöglichen, benötigt die bekannte Sicherheitsschaltvorrichtung daher relativ viele Anschlussklemmen.

Die DE 43 37 665 C1 offenbart eine aus zwangsgeführten Hilfsschützen aufgebaute Schützsicherheitskombination. Mit dieser Schaltung kann ein Antrieb über einen Freigabekreis an eine Versorgungsspannung dann zugeschaltet werden, wenn sämtliche Hilfsschütze fehlerfrei arbeiten. Die Schaltung ist dabei zur Freigabe eines Antriebs für Gleichspannungsanschluss ausgelegt. Diese Grundschaltung weist insgesamt drei Hilfsschütze und somit drei Spulen auf. Eine dieser Spulen ist mit einem Öffnerkontakt eines Not-Aus-Tasters in Reihe geschaltet. Die beiden anderen Spulen sind zueinander parallel geschaltet, wobei diese Parallelschaltung in Reihe zu einem Schließerkontakt eines Ein-Tasters geschaltet ist. Sowohl zu der einzelnen Spule als auch zu den beiden parallel geschalteten Spulen ist jeweils eine Freilaufdiode parallel geschaltet. In einer abgewandelten Form kann diese Schaltung auch zur Freigabe eines Antriebs für Wechselspannungsanschluss eingesetzt werden. Hierbei kommt die für den Gleichspannungsanschluss konzipierte Grundschaltung zum Einsatz, wobei sowohl die Parallelschaltung, bestehend aus der einzelnen Spule und der Freilaufdiode, als auch die Parallelschaltung bestehend aus den beiden Spulen und der Freilaufdiode, jeweils durch einen Brückengleichrichter ersetzt ist. Im Fall der einzelnen Spule ist diese im Brückenzweig des Brückengleichrichters angeordnet. Im Fall der beiden parallel geschalteten Spulen sind diese im Brückenzweig des Brückengleichrichters angeordnet. Somit ist eine Maßnahme bekannt, mit der eine Sicherheitsschaltvorrichtung, die für einen Betrieb mit Gleichspannung konzipiert ist, prinzipiell auch für den Betrieb mit einer Wechselspannung eingesetzt werden kann. Die Schützsicherheitskombination ist jedoch nicht für den Betrieb in unterschiedlichen Betriebsarten, insbesondere einer Betriebsart mit Querschlusserkennung und einer Betriebsart ohne Querschlusserkennung ausgebildet, und somit hinsichtlich der Verwendungsvielfalt begrenzt.

Die eingangs genannte DE 44 23 704 C1 offenbart eine Sicherheitsschaltvorrichtung, bei der ein erstes Meldesignal dem Steuerkreis eines ersten Schaltelements über einen ersten Anschluss zugeführt wird, während ein zweites Meldesignal zum Steuerkreis eines zweiten Schaltelements über einen zweiten Anschluss geführt ist. Dadurch, dass die Steuerkreise der beiden Schaltelemente außerdem an einem gemeinsamen Massepotential liegen und dass die Meldesignale einen positiven und einen negativen Signalpegel bezogen auf das gemeinsame Massepotential haben, kann ein Querschluss zwischen den beiden Meldesignalen erkannt werden.

Diese bekannte Sicherheitsschaltvorrichtung ermöglicht jedoch keinen Betrieb ohne Querschlusserkennung und sie ist dementsprechend in Bezug auf die Verwendungsvielfalt begrenzt. Darüber hinaus benötigt diese bekannte Sicherheitsschaltvorrichtung eine Wechselspannungsversorgung, was die Einsatzmöglichkeiten weiter einschränkt.

Vor diesem Hintergrund ist es eine Aufgabe der vorliegenden Erfindung, eine Sicherheitsschaltvorrichtung der eingangs beschriebenen Art anzugeben, die flexible Einsatz- und Anschlussmöglichkeiten bietet und auf möglichst kleinem Bauraum realisiert werden kann.

Gemäß einem Aspekt der Erfindung wird diese Aufgabe durch eine Sicherheitsschaltvorrichtung der eingangs genannten Art gelöst, welches ein Schaltnetzwerk mit einem ersten Strompfad, einem alternativen zweiten Strompfad und zumindest einem weiteren Schaltelement besitzt, wobei das zweite Meldesignal unterschiedliche Polaritäten annahmen kann, und das zumindest eine weitere Schaltelement dazu ausgebildet ist, in Abhängigkeit von der Polarität des zweiten Meldesignals entweder den ersten oder den zweiten Strompfad zu schließen, um das zweite Meldesignal zu dem zweiten Steuerkreis zu führen, sodass in Abhängigkeit von der verwendeten Polarität eine Verdrahtung mit oder ohne Querschlusserkennung möglich ist.

Die neue Sicherheitsschaltvorrichtung besitzt also zumindest zwei alternative Strompfade, die vorzugsweise zumindest teilweise zwischen dem zweiten Anschluss und dem zweiten Steuerkreis angeordnet sind. Dadurch kann das Meldesignal am zweiten Anschluss der Sicherheitsschaltvorrichtung auf unterschiedliche Weise zu dem zweiten Steuerkreis geführt werden. Da die Auswahl zwischen den zumindest zwei alternativen Strompfaden von der Polarität des Meldesignals am zweiten Anschluss abhängt, ist die neue Sicherheitsschaltvorrichtung in der Lage, Meldesignale unterschiedlicher Polarität am zweiten Anschluss zu verarbeiten. Mit anderen Worten können Meldesignale unterschiedlicher Polarität an dem zweiten Anschluss zugeführt werden. Abhängig von der verwendeten Polarität ist eine Verdrahtung mit oder ohne Querschlusserkennung möglich, wobei die Meldesignale in beiden Fällen über gleiche Anschlussklemmen zugeführt werden.

Infolgedessen kann die neue Sicherheitsschaltvorrichtung mit einer geringeren Anzahl an Anschlussklemmen realisiert werden als die eingangs erwähnte Sicherheitsschaltvorrichtung PNOZ X8P der Anmelderin. Dementsprechend ist auch eine Realisierung auf geringerem Bauraum möglich, weil gerade die Anzahl der benötigten Anschlussklemmen die Baugröße beeinflusst. Die klemmensparende Realisierung der neuen Sicherheitsschaltvorrichtung ermöglicht somit eine Reduzierung des Bauraums, ohne die Einsatzmöglichkeiten zu beschränken. Die genannte Aufgabe ist daher vollständig gelöst.

Darüber hinaus ermöglicht die neue Sicherheitsschaltvorrichtung eine sehr einfache und kostengünstige Realisierung, weil die Meldesignale direkt zum Aktivieren oder Deaktivieren der Schaltelemente verwendet werden können. Mit anderen Worten können die Meldesignale hier die Energie zum Ein- und/oder Ausschalten der Schaltelemente liefern, was in praktischen Ausführungsbeispielen der Erfindung auch bevorzugt ist. Ein Wegfall eines Meldesignals führt folglich direkt zu einem Abschalten des zugehörigen Schaltelements und damit zu einem Abschalten des überwachten elektrischen Verbrauchers.

Die neue Sicherheitsschaltvorrichtung kann daher sehr kostengünstig realisiert werden und sie eignet sich besonders für "kleine" Anwendungen, bei denen nur wenige Sicherheitsfunktionen überwacht werden müssen.

In einer bevorzugten Ausgestaltung ist die Sicherheitsschaltvorrichtung dazu ausgebildet, das erste und das zweite Meldesignal bei einer Verdrahtung mit oder ohne Querschlusserkennung über gleiche Anschlussklemmen zu führen.

In einer bevorzugten Ausgestaltung beinhaltet das Schaltnetzwerk eine Vielzahl von ersten weiteren Schaltelementen, die einen Brückcngleichrichter bilden. Bevorzugt sind die ersten weiteren Schaltelemente Dioden, so dass es sich um eine Diodenbrücke zur Gleichrichtung des zweiten Meldesignals handelt.

Diese Ausgestaltung ist eine besonders kostengünstige Möglichkeit, um den zweiten Steuerkreis unabhängig von der Polarität des Meldesignals mit Energie zu versorgen. Insbesondere ermöglicht diese Ausgestaltung eine Reduzierung bei der Anzahl der benötigten Bauelemente, da gepolte Bauelemente, wie beispielsweise Elektrolytkondensatoren oder Optokoppler, die in der Regel zur Versorgung und Überwachung des zweiten Steuerkreises benötigt werden, jeweils nur einfach bereitgestellt werden müssen.

In einer weiteren Ausgestaltung besitzt der Brückengleichrichter einen ersten und einen zweiten Brückenanschluss, zwischen denen der zweite Steuerkreis angeordnet ist.

In dieser Ausgestaltung sitzt der zweite Steuerkreis im Brückenzweig des Brückengleichrichters. Diese Ausgestaltung ermöglicht eine besonders einfache und kostengünstige Realisierung.

In einer weiteren Ausgestaltung besitzt der Brückengleichrichter einen dritten und einen vierten Brückenanschluss, wobei der dritte Brückenanschluss mit dem zweiten Anschluss gekoppelt ist und wobei der vierte Anschluss mit einem definierten Referenzpotential belegt ist. Dabei kann das Referenzpotential fest oder variabel, insbesondere umschaltbar, sein.

Diese Ausgestaltung sorgt für einen definierten Stromfluss durch den Brückengleichrichter in Abhängigkeit von dem Meldesignal am zweiten Anschluss der Sicherheitsschaltvorrichtung. Abhängig von der Polarität des zweiten Meldesignals werden lediglich unterschiedliche Strompfade innerhalb des Brückengleichrichters durchflossen, wobei diese Strompfade von den Schaltelementen (Dioden) des Brückengleichrichters geschaltet werden. Darüber hinaus wird mit dieser Ausgestaltung auch der Signalpegel des zweiten Meldesignals zumindest qualitativ überwacht, da ein ausreichender Stromfluss durch die Pfade des Brückengleichrichters nur möglich ist, wenn eine definierte Potentialdifferenz zwischen dem Referenzpotential und dem zweiten Meldesignal besteht. Diese Ausgestaltung ist folglich eine einfache und kostengünstige Realisierung, die eine zusätzliche Sicherheit bietet.

In einer weiteren Ausgestaltung wechselt das zweite Meldesignal zwischen einem hohen ersten und einem niedrigen zweiten Signalpegel, wobei das definierte Referenzpotential etwa mittig zwischen dem ersten und zweiten Signalpegel liegt. Einer der Signalpegel kann in dieser Ausgestaltung auch ein hochohmiger, unbeschalteter Zustand an dem zweiten Anschluss sein.

Diese Ausgestaltung ermöglicht auf einfache Weise einen automatischen Betrieb der neuen Sicherheitsschaltvorrichtung mit zweiten Meldesignalen unterschiedlicher Polarität. Es genügt, wenn der Anwender (beispielsweise ein Monteur, der die neue Sicherheitsschaltvorrichtung in einer Maschine oder Anlage verdrahtet) die Signalleitung, die das zweite Meldesignal überträgt, an den zweiten Anschluss anschließt. Die neue Sicherheitsschaltvorrichtung dieser Ausgestaltung kann ohne weitere Einstellungen der Betriebsart (mit oder ohne Querschlusserkennung) in Betrieb genommen werden. Diese Ausgestaltung ist daher für den Anwender sehr komfortabel.

In einer weiteren Ausgestaltung beinhaltet das Schaltnetzwerk zumindest ein zweites weiteres Schaltelement, das dazu ausgebildet ist, den zweiten Steuerkreis wahlweise mit einem ersten oder einem zweiten Betriebspotential zu verbinden. Vorzugsweise sind das erste und das zweite Betriebspotential Festpotentiale. In einem besonders bevorzugten Ausführungsbeispiel ist das erste Betriebspotential eine Betriebsgleichspannung und das zweite Betriebspotential ist Masse.

Des Weiteren ist es bevorzugt, wenn das Schaltnetzwerk zumindest zwei Transistoren (als zweite weitere Schaltelemente) in einer Halbbrückenanordnung aufweist, die zwischen der internen Betriebsspannung der Sicherheitsschaltvorrichtung und Masse angeordnet sind.

Diese Ausgestaltungen sind besonders bevorzugt, wenn die Meldesignale ebenfalls zwischen Betriebsspannung und Masse wechseln, wobei Betriebsspannung den sicheren Zustand signalisiert. Indem man den zweiten Steuerkreis wahlweise (in Abhängigkeit von der Polarität des zweiten Meldesignals) mit dem ersten oder dem zweiten Betriebspotential verbindet, lässt sich der Steuerkreis unabhängig von der Polarität des zweiten Meldesignals in jeweils gleicher Weise betreiben. Der Steuerkreis kann unabhängig von der gewählten Betriebsart arbeiten, und er erhält jeweils eine maximale Schaltenergie, was eine sehr zuverlässige Funktion der neuen Sicherheitsschaltvorrichtung gewährleistet. Darüber hinaus kommt diese Ausgestaltung mit wenigen internen Potentialen aus, was einen fehlersicheren Aufbau erleichtert.

In einer weiteren Ausgestaltung beinhaltet die neue Sicherheitsschaltvorrichtung eine Steuereinheit, die dazu ausgebildet ist, den zweiten Steuerkreis so lange wechselweise mit dem ersten oder dem zweiten Betriebspotential zu verbinden, bis ein Stromfluss im zweiten Steuerkreis detektierbar ist.

Auch in dieser Ausgestaltung kann sich die neue Sicherheitsschaltvorrichtung automatisch auf das Meldesignal am zweiten Anschluss einstellen, da ein Stromfluss im zweiten Steuerkreis darauf hindeutet, dass die entsprechende Schaltstellung des zweiten weiteren Schaltelements die "richtige" Schaltstellung ist, um das angelegte zweite Meldesignal auszuwerten. Auch diese Ausgestaltung ist daher für den Anwender eine sehr bequeme Lösung, die die Installation der neuen Sicherheitsschaltvorrichtung vereinfacht.

Vorzugsweise beinhaltet diese Ausgestaltung außerdem einen Stromdetektor, der mit dem zweiten Steuerkreis verbunden ist, um den Stromfluss im zweiten Steuerkreis zu detektieren, wobei der Stromdetektor dann mit der Steuereinheit verbunden ist.

In einer weiteren Ausgestaltung beinhaltet die neue Sicherheitsschaltvorrichtung eine Freigabeeinheit, die dazu ausgebildet ist, die Steuereinheit zu blockieren, sobald ein Stromfluss im zweiten Steuerkreis detektiert ist.

Diese Ausgestaltung ermöglicht es, das erste und zweite Schaltelement als "Fehlerspeicher" zu verwenden, da die Schaltstellung des zweiten Schaltelements von der Steuereinheit nachträglich nicht mehr verändert werden kann. Damit erleichtert diese Ausgestaltung den Aufbau von besonders einfachen und kostengünstigen Sicherheitsschaltvorrichtungen.

In einer weiteren Ausgestaltung beinhaltet die Sicherheitsschaltvorrichtung ein Stellelement mit zumindest zwei Stellpositionen, wobei das Stellelement mit dem zumindest einen zweiten weiteren Schaltelement betriebsmäßig gekoppelt ist, um den zweiten Steuerkreis wahlweise mit dem ersten oder dem zweiten Betriebspotential zu verbinden. Bevorzugt ist das Stellelement manuell zu betätigen.

In dieser Ausgestaltung besitzt der Anwender die Möglichkeit, die "Art" des zweiten Meldesignals gezielt einzustellen. Bevorzugte Ausgestaltungen verzichten damit auf den Vorteil der oben diskutierten Varianten, bei denen die Sicherheitsschaltvorrichtung die Art des zweiten Meldesignals automatisch erkennt. Andererseits besitzt die vorliegende Ausgestaltung den Vorteil, dass sowohl einpolige als auch zweipolige Meldesignale fehlerfrei verarbeitet werden können. Ein einpoliges Meldesignal ist ein Meldesignal, das zwischen einem definierten Potential und einem hochohmigen Zustand wechselt. Typischerweise werden einpolige Meldesignale von kontaktbehafteten Meldegeräten, wie etwa einen Not-Aus-Taster, erzeugt. Zweipolige Meldesignale wechseln zwischen einem höheren und einem niedrigeren Potential, beispielsweise zwischen 24V und OV (Masse). Solche Meldesignale werden typischerweise von Lichtschranken und anderen Meldegeräten mit Halbleiterausgängen geliefert.

Die vorliegende Ausgestaltung erhöht die Einsatzmöglichkeiten der neuen Sicherheitsschaltvorrichtung. Dadurch lassen sich Herstellungs- und Lagerkosten reduzieren.

In einer weiteren Ausgestaltung ist zumindest das zweite Schaltelement ein elektromechanisches Schaltelement, vorzugsweise ein ungepoltes elektromechanisches Schaltelement.

Diese Ausgestaltung ist von Vorteil, weil ein elektromechanisches Schaltelement ein potentialfreies Ausgangsschaltsignal zum Abschalten des Verbrauchers bereitstellt. Ein solches Ausgangsschaltsignal ist in einer Vielzahl von Einsatzumgebungen verwendbar, so dass die Anwendungsbreite der neuen Sicherheitsschaltvorrichtung erhöht ist. Ein ungepoltes elektromechanisches Schaltelement ist von Vorteil, weil ein Steuerstrom dann in beiden Richtungen wirksam fließen kann. Diese Ausgestaltung erleichtert die praktische Realisierung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Figur 1: eine schematische Darstellung einer automatisiert arbeitenden Anlage, in der Ausführungsbeispiele der neuen Sicherheitsschaltvorrichtung zum Einsatz kommen,
- Figur 2: eine vereinfachte Darstellung eines Ausführungsbeispiels der neuen Sicherheitsschaltvorrichtung,
- Figur 3: ein stark vereinfachtes Ersatzschaltbild mit der Verschaltung des zweiten Schaltelements gemäß einem weiteren Ausführungsbeispiel, und
- Figur 4: ein stark vereinfachtes Ersatzschaltbild eines weiteren Ausführungsbeispiels.

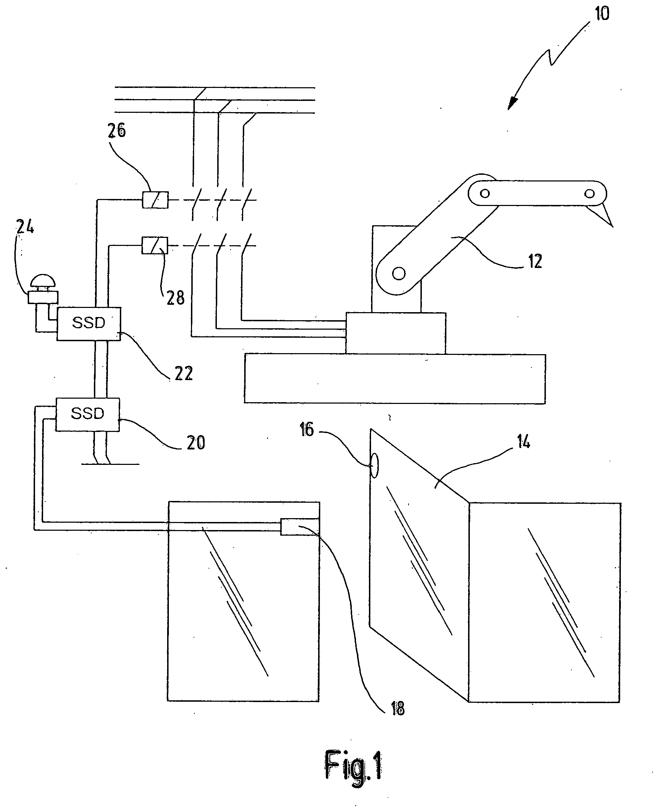

In Figur 1 ist eine Anlage, in der Ausführungsbeispiele der Erfindung zum Einsatz kommen, in ihrer Gesamtheit mit der Bezugsziffer 10 bezeichnet.

Die Anlage 10 beinhaltet einen Roboter 12, dessen Arbeitsraum mit einer Schutztür 14 abgesichert ist. An der Schutztür 14 ist ein Betätiger 16 angeordnet, der mit einem Schutztürschalter 18 zusammenwirkt. Der Schutztürschalter 18 sitzt an einem Rahmen, an dem die bewegliche Schutztür 14 im geschlossenen Zustand anliegt. Der Betätiger 16 kann beispielsweise ein Transponder sein, der mit dem Schutztürschalter 18 nur bei geschlossener Schutztür 14 kommunizieren kann.

Der Schutztürschalter 18 ist mit einem Sicherheitsschaltgerät 20 verbunden, das die Meldesignale des Schutztürschalters 18 verarbeitet. In Reihe zu dem Sicherheitsschaltgerät 20 befindet sich ein zweites Sicherheitsschaltgerät 22, an dem ein Not-Aus-Taster 24 als Meldegerät angeschlossen ist. Die Sicherheitsschaltgeräte 20, 22 sind kompakte Sicherheitsschaltvorrichtungen im Sinne der vorliegenden Erfindung, die einen herstellerseitig festgelegten Funktionsumfang haben. Grundsätzlich kann die Erfindung jedoch auch bei komplexeren, programmierbaren Sicherheitssteuerungen eingesetzt werden.

Mit den Bezugsziffern 26, 28 sind zwei Schütze bezeichnet, deren Arbeitskontakte im Stromversorgungspfad zu dem Roboter 12 liegen. Die Steuerkreise der Schütze 26, 28 werden über die Sicherheitsschaltgeräte 20, 22 mit Strom versorgt, so dass jedes der Sicherheitsschaltgeräte 20, 22 in der Lage ist, den Roboter 12 über die Schütze 26, 28 abzuschalten. Eine Betriebssteuerung, die den normalen Betriebsablauf des Roboters 12 steuert, ist der Einfachheit halber nicht dargestellt.

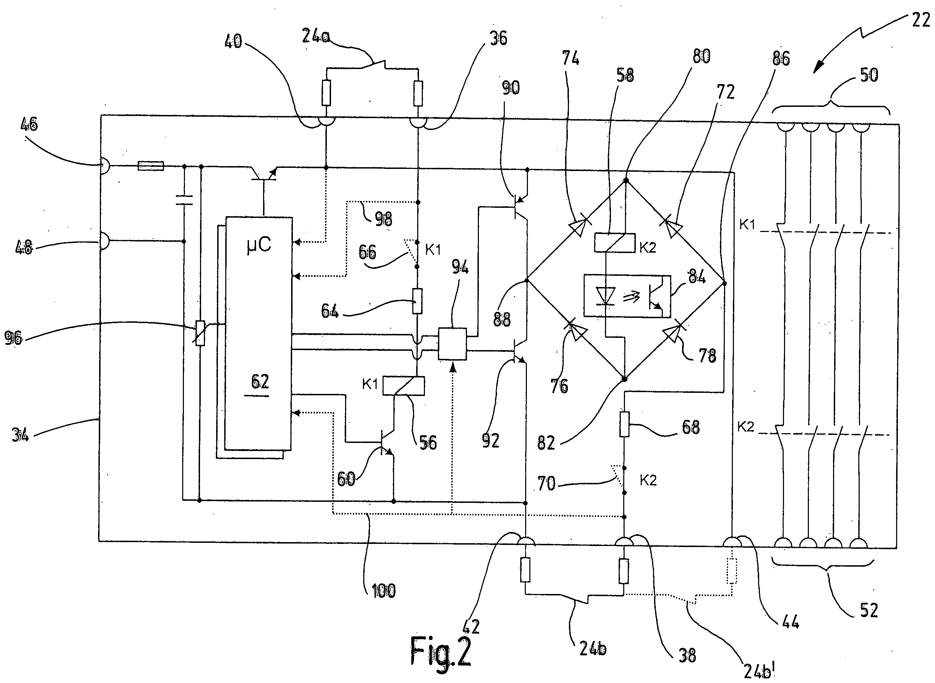

In Figur 2 ist ein bevorzugtes Ausführungsbeispiel der Erfindung anhand des Sicherheitsschaltgerätes 22 dargestellt. Gleiche Bezugszeichen bezeichnen dieselben Elemente wie zuvor.

Das Sicherheitsschaltgerät 22 besitzt ein Gerätegehäuse 34 mit einer Vielzahl von Anschlussklemmen zum Anschließen des Not-Aus-Tasters 24, der Schütze 26, 28 und von möglichen weiteren Meldegeräten und Aktoren (hier nicht dargestellt). Mit dem Bezugszeichen 36 ist eine erste Anschlussklemme bezeichnet, an die ein erster Öffnerkontakt 24a des Not-Aus-Tasters 24 angeschlossen ist. Mit der Bezugsziffer 38 ist eine zweite Anschlussklemme bezeichnet, an die ein zweiter Öffnerkontakt 24b des Not-Aus-Tasters 24 angeschlossen ist. Die Sicherheitsschaltvorrichtung 22 erhält somit über die Anschlussklemme 36 ein erstes Meldesignal, das von der Schaltposition des Meldekontaktes 24a abhängt, und über die Anschlussklemme 38 ein zweites Meldesignal, das von der Schaltposition des Meldekontaktes 24b abhängt.

In dem dargestellten Ausführungsbeispiel ist der Öffnerkontakt 24a ferner mit einer Anschlussklemme 40 verbunden, an der geräteintern eine Betriebsspannung U_{B} von zum Beispiel 24 V anliegt. Bei geschlossenem Öffnerkontakt 24a liegt folglich auch an der Anschlussklemme 36 die Betriebsspannung U_{B} als Meldesignal. Bei geöffnetem Meldekontakt 24a (hier nicht dargestellt) ist die Anschlussklemme 36 hochohmig belegt.

Der Öffnerkontakt 24b ist in diesem Ausführungsbeispiel ferner mit einer Anschlussklemme 42 verbunden, die geräteintern an Masse liegt. Dementsprechend ist die Anschlussklemme 38 bei geschlossenem Öffnerkontakt 24b mit der Gerätemasse verbunden. Bei geöffnetem Öffnerkontakt 24b ist die Anschlussklemme 38 ebenfalls hochohmig.

Die Bereitstellung der über die Öffnerkontakte 24a, 24b geführten Meldesignale an geräteeigenen Ausgangsklemmen 40, 42 ist eine typische Realisierung für Sicherheitsschaltgeräte der vorliegenden Art. Die Erfindung ist jedoch auf diese Ausführung nicht beschränkt. Vielmehr können an die Anschlussklemmen 36, 38 auch Meldesignale angelegt werden, die extern mit Hilfe eines anderen Gerätes erzeugt werden, beispielsweise mit Hilfe einer Lichtschranke (hier nicht dargestellt). In diesem Fall können die Anschlussklemmen 40, 42 unbelegt bleiben.

In der dargestellten Variante kann das Sicherheitsschaltgerät 22 einen Querschluss zwischen den Meldeleitungen erkennen, weil das Meldesignal an der Anschlussklemme 36 im sicheren Zustand der Betriebsspannung U_{B} entspricht, während das Meldesignal an der zweiten Anschlussklemme 38 im sicheren Zustand dem Massepotential entspricht. Ein Querschluss zwischen den Signalleitungen, die die Meldesignale führen, hätte zur Folge, dass das Potential an der ersten Anschlussklemme 36 gegen Masse gezogen wird, was in einer nachfolgend beschriebenen Weise erkannt werden kann.

Alternativ hierzu kann die Sicherheitsschaltvorrichtung 22 auch ohne Querschlusserkennung auf den Meldeleitungen betrieben werden, wenn dies aufgrund einer geringeren Sicherheitskategorie zulässig und sinnvoll ist. In diesem Fall würde der zweite Meldekontakt 24b des Not-Aus-Tasters 24 von der zweiten Anschlussklemme 38 zu einer Anschlussklemme 44 gelegt, wie dies in punktierter Linie bei der Bezugsziffer 24b' dargestellt ist. Die Anschlussklemme 44 ist geräteintern mit der Betriebsspannung U_{B} belegt, so dass dann beide Meldekontakte 24a, 24b' im sicheren Zustand die Betriebsspannung U_{B} führen würden. Eine Querschlusserkennung ist in diesem Fall nicht möglich.

Alternativ zu dieser Darstellung könnte der zweite Meldekontakt 24b' auch zwischen den Anschlussklemmen 38 und 40 angeordnet werden, das heißt die eingangsseitigen Anschlüsse der Meldekontakte 24a, 24b' wären an der Anschlussklemme 40 parallel geschaltet. Diese Realisierung ermöglicht es, auf die Anschlussklemme 44 zu verzichten, um weiteren Bauraum zu sparen.

Zwei weitere Anschlussklemmen 46, 48 dienen dazu, das Sicherheitsschaltgerät 22 mit der Betriebsspannung U_{B} von beispielsweise 24 V zu versorgen. Weitere Anschlussklemmen 50, 52 sind dazu vorgesehen, die Schütze 26, 28 und mögliche weitere Verbraucher anzuschließen.

In dem dargestellten Ausführungsbeispiel weist das Sicherheitsschaltgerät 22 potentialfreie Ausgänge in Form von Relaiskontakten auf, die zwischen den Anschlussklemmen 50, 52 in Reihe zueinander liegen. In einem solchen Fall wird an die Anschlussklemmen 50 ein positives Potential von beispielsweise 24 V angeschlossen, und die Schütze 26, 28 werden an die Anschlussklemmen 52 angeschlossen. Über die Relaiskontakte K1, K2 können die Schütze 26, 28 bestromt werden, oder der Stromfluss kann unterbrochen werden. Alternativ oder ergänzend hierzu kann die vorliegende Erfindung jedoch auch bei Sicherheitsschaltvorrichtungen eingesetzt werden, die potentialbezogene Halbleiterausgänge aufweisen.

Die Relais K1, K2 besitzen jeweils einen Steuerkreis, der in Figur 2 mit den Bezugsziffern 56, 58 bezeichnet ist. Die Steuerkreise 56, 58 sind hier die Erregerspulen der Relais K1, K2. Wie in Figur 2 dargestellt ist, ist der Steuerkreis (Erregerspule) 56 des Relais K1 mit einem Anschluss zur Masse geführt, wobei in dieser Verbindung noch die Kollektor-Emitter-Strecke eines Transistors 60 angeordnet ist, über den ein Mikrocontroller 62 den Stromfluss durch die Erregerspule 56 unterbrechen kann. Der andere Anschluss des Steuerkreises 56 führt über einen Widerstand 64 und einen Schließerkontakt 66 des Relais K1 zu der Anschlussklemme 36. Der Widerstand 64 ist ein symbolischer Ersatzwiderstand, der für weitere hier nicht dargestellte Bauelemente und Leitungswiderstände repräsentativ ist. Der Schließerkontakt 66 realisiert eine Selbsthaltung des Relais K1, die bei Sicherheitsschaltgeräten der vorliegenden Art seit vielen Jahren verwendet wird und die den Fachlauten auf diesem Gebiet daher bekannt ist.

Insgesamt ist das Meldesignal an der Anschlussklemme 36 also über den Steuerkreis 56 des Relais K1 geführt und es liefert die Energie zum Halten des Relais K1. (Zum Anziehen des Relais K1 muss die Energie über einen Startkreis zugeführt werden, der hier aus Gründen der Übersichtlichkeit nicht dargestellt ist.) Wenn das Meldesignal an der Anschlussklemme 36 der Betriebsspannung U_{B} entspricht und sich das Relais K1 in Selbsthaltung befindet (Schließerkontakt 66 geschlossen), fließt ein Steuerstrom durch die Erregerspule des Relais K1 und die Arbeitskontakte des Relais K1 sind geschlossen (nicht dargestellt).

In gleicher Weise ist der Steuerkreis 58 des Relais K2 über einen symbolischen Ersatzwiderstand 68 und einen Schließerkontakt 70 (für die Selbsthaltung) mit der zweiten Anschlussklemme 38 verbunden. Allerdings liegt der Steuerkreis 58 des Relais K2 - im Unterschied zu dem Steuerkreis 56 des Relais K1 - in diesem Ausführungsbeispiel in einer Diodenbrücke, die aus vier Dioden 72, 74, 76, 78 in Brückenschaltung besteht. Die Diodenbrücke besitzt einen ersten und einen zweiten Brückenanschluss 80, 82, zwischen denen der Steuerkreis 58 des Relais K2 sowie ein Optokoppler 84 angeordnet sind. Der Optokoppler 84 dient hier als Stromdetektor, mit dessen Hilfe der Mikrocontroller 62 feststellen kann, ob im Brückenzweig zwischen den Brückenanschlüssen 80, 82 ein Strom fließt. Anstelle eines Optokopplers könnte auch ein anderes Element zur Stromdetektion verwendet werden, wie zum Beispiel ein Shunt-Widerstand oder ein Hall-Element.

Darüber hinaus besitzt die Diodenbrücke einen dritten und einen vierten Brückenanschluss 86, 88. Der dritte Brückenanschluss 86 ist über den Widerstand 68 und den Schließerkontakt 70 mit der Anschlussklemme 38 verbunden. (Alternativ hierzu könnten der Widerstand 68 und der Schließerkontakt 70 auch in dem Brückenzweig der Diodenbrücke angeordnet sein.) Der vierte Brückenanschluss 88 ist mit dem Kollektor eines pnp-Transistors 90 und mit dem Kollektor eines npn-Transistors 92 verbunden. Die Transistoren 90, 92 bilden eine Halbbrücke, die zwischen der Betriebsspannung U_{B} und Masse angeordnet ist. Dementsprechend liegt der Emitter des pnp-Transistors 90 an der Betriebsspannung U_{B} und der Emitter des npn-Transistors 92 liegt an Masse. Die Steueranschlüsse (Basen) der Transistoren 90, 92 sind über eine Freigabeeinheit 94 dem Mikrocontroller 62 zugeführt.

Die Diodenbrücke stellt einen ersten und einen alternativen zweiten Strompfad zu dem Steuerkreis 58 des Relais K2 bereit. Wenn das zweite Meldesignal an der Anschlussklemme 38, wie in Figur 2 dargestellt ist, dem Massepotential entspricht, und wenn zudem der pnp-Transistor 90 leitend und der npn-Transistor 92 sperrend geschaltet ist, sind die Dioden 74, 78 in Durchlassrichtung geschaltet und es ergibt sich ein Stromfluss über den pnp-Transistor 90, den vierten Brückenanschluss 88, die Diode 74, den Steuerkreis 58 des Relais K2, den Optokoppler 84 die Diode 78, den Brückenanschluss 86, den Widerstand 68, den Schließerkontakt 70 und den Meldekontakt 24b zur Masse.

Wenn hingegen der Meldekontakt 24b' auf die Betriebsspannung U_{B} verdrahtet ist, und wenn zudem der Transistor 90 sperrend und der Transistor 92 leitend geschaltet ist, ergibt sich ein Stromfluss über den Meldekontakt 24b', den Schließerkontakt 70, den Widerstand 68, die Diode 72, den Steuerkreis 58 des Relais K2, den Optokoppler 84, die Diode 76 und den Transistor 92. In beiden Fällen wird der Steuerkreis 58 von einem Steuerstrom durchflossen, der zur Folge hat, dass die Arbeitskontakte des Relais K2 anziehen können.

Die Dioden 72, 74, 76, 78 stellen somit Schaltelemente dar, die in Abhängigkeit von der Polarität des Meldesignals an der Anschlussklemme 38 unterschiedliche Strompfade zu dem Steuerkreis 58 des Relais K2 bilden. Darüber hinaus sind die Transistoren 90, 92 Schaltelemente, mit deren Hilfe der Mikrocontroller 62 die unterschiedlichen Strompfade gezielt aktivieren bzw. deaktivieren kann.

Mit der Bezugsziffer 96 ist ein Potentiometer als Beispiel für ein manuell betätigbares Stellelement bezeichnet. Das Potentiometer 96 liegt mit einem Anschluss an der Betriebsspannung U_{B} und mit einem zweiten Anschluss an Masse. Der Abgriff des Potentiometers ist dem Mikrocontroller 62 zugeführt. An Stelle eine Potentiometers könnte hier auch ein Drehschalter, DIP-Schalter oder ein anderes manuell zu betätigendes Stellelement verwendet werden. Der Mikrocontroller 62 kann anhand der Stellposition des Stellelements 96 erkennen, in welcher Betriebsart das Sicherheitsschaltgerät 22 arbeiten soll.

Im vorliegenden Ausführungsbeispiel erkennt der Mikrocontroller 62 insbesondere, ob das Sicherheitsschaltgerät 22 mit oder ohne Querschlusserkennung zwischen den Meldesignalen an den Anschlussklemmen 36, 38 arbeiten soll. Wenn mit Hilfe des Potentiometers 96 eine Betriebsart mit Querschlusserkennung gewählt ist, schaltet der Mikrocontroller 62 den pnp-Transistor 90 leitend und den npn-Transistor 92 sperrend. Damit liegt der Brückenanschluss 88 an Betriebsspannung U_{B} und es ergibt sich ein Stromfluss durch den Brückenzweig und über den Steuerkreis 58 des Relais K2, wenn ein Massepotential am zweiten Anschluss 38 anliegt (zusätzlich muss auch ein Betriebsspannungspotential an der ersten Anschlussklemme 36 anliegen, damit das Relais K2 anziehen kann, was hier aus Gründen der Übersichtlichkeit jedoch nicht näher dargestellt ist). Wenn hingegen mit Hilfe des Potentiometers 96 eine alternative Betriebsart gewählt wird, die ohne Querschlusserkennung an den Meldesignalen arbeitet, schaltet der Mikrocontroller 62 den pnp-Transistor 90 sperrend und den npn-Transistor 92 leitend. In diesem Fall muss an der Anschlussklemme 38 ein Betriebsspannungspotential anliegen, damit ein Steuerstrom durch den Brückenzweig und über den Steuerkreis 58 des Relais K2 fließen kann.

Die Querschlusserkennung zwischen den Meldesignalen an den Anschlussklemmen 36, 38 ist in dem dargestellten Ausführungsbeispiel dadurch realisiert, dass der Mikrocontroller die Potentiale an den beiden Anschlussklemmen messtechnisch erfasst, was anhand von zwei Messleitungen 98, 100 vereinfacht dargestellt ist. In einem bevorzugten Ausführungsbeispiel besitzt der Mikrocontroller 62 integrierte A/D-Wandler, mit deren Hilfe er die Potentiale an den Anschlussklemmen 36, 38 über die Messleitungen 98, 100 erfasst. Durch einen Plausibilitätsvergleich der aufgenommenen Potentiale lässt sich ein Querschluss erkennen. Diese Art der Querschlusserkennung ist Gegenstand einer älteren deutschen Patentanmeldung der vorliegenden Anmelderin mit dem Aktenzeichen DE 10 2005 055 325.7-32, auf die hier zur weiteren Erläuterung ausdrücklich verwiesen ist.

Alternativ hierzu kann die Querschlusserkennung selbst jedoch auch in konventioneller Weise realisiert sein, etwa wie bei dem eingangs erwähnten Sicherheitsschaltgerät PNOZ X8P.

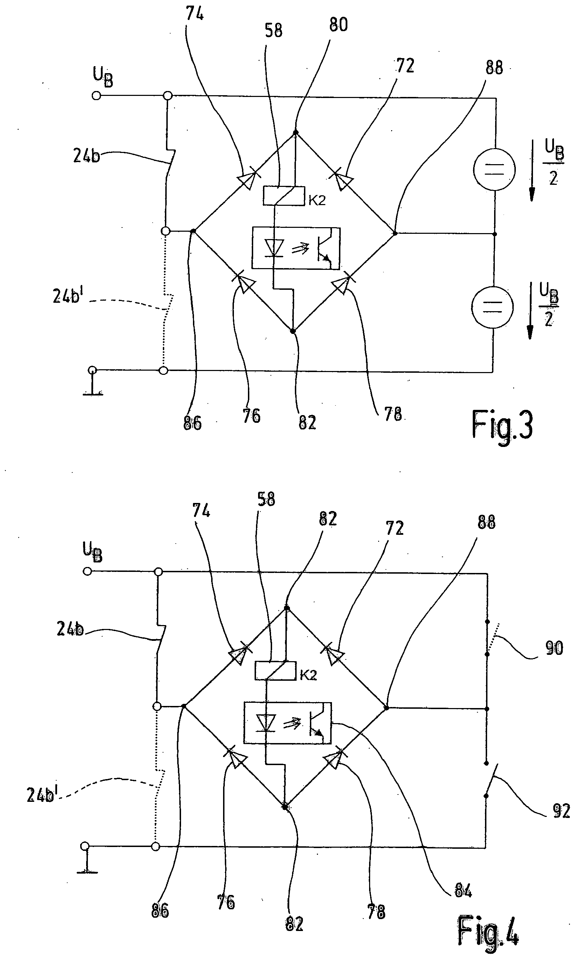

In dem Ausführungsbeispiel gemäß Figur 2 ist das an der Anschlussklemme 38 erfasste Potential auch der Freigabeeinheit 94 zugeführt. Die Funktion der Freigabeeinheit 94 wird weiter unten anhand der Figur 4 näher erläutert. In anderen Ausführungsbeispielen der Erfindung kann die Freigabeeinheit 94 entfallen.

Schließlich ist in einem bevorzugten Ausführungsbeispiel des neuen Sicherheitsschaltgerätes 22 ein einkanaliger Mikrocontroller 62 vorgesehen. Alternativ hierzu können jedoch auch zwei redundante Mikrocontroller 62 verwendet werden, wie dies in Figur 2 vereinfacht dargestellt ist. Darüber hinaus können an Stelle der Mikrocontroller 62 auch andere Logikbausteine, wie etwa ein FPGA oder ein ASIC verwendet werden, oder das Sicherheitsschaltgerät kann unter Verwendung der vorliegenden Erfindung vollständig aus diskreten Bauelementen aufgebaut werden.

Figur 3 zeigt eine Abwandlung des Ausführungsbeispiels aus Figur 2 in einem stark vereinfachten Ersatzschaltbild, das im Wesentlichen den Brückengleichrichter mit dem zweiten Steuerkreis und die alternativen Anschlussmöglichkeiten für den zweiten Meldekontakt 24b/24b' zeigt. Im Übrigen bezeichnen gleiche Bezugszeichen dieselben Elemente wie zuvor.

In der Abwandlung gemäß Figur 3 wird der Meldekontakt 24b bzw. 24b' wiederum an den Brückenanschluss 86 der Diodenbrücke angeschlossen, und zwar wahlweise gegen Betriebsspannung U_{B} oder gegen Masse. Der gegenüberliegende Brückenanschluss 88 liegt hier jedoch auf einem Potential, das der halben Betriebsspannung U_{B}/2 entspricht. Durch diese Realisierung kann auf die Transistoren 90, 92 verzichtet werden.

Dadurch, dass über dem Brückenzweig zwischen den Brückenanschlüssen 80, 82 stets die halbe Betriebsspannung U_{B}/2 anliegt, kann ein Steuerstrom über den Steuerkreis 58 des Relais K2 in beiden Alternativen fließen, ohne dass eine manuelle Umschaltung erfolgen muss. Lediglich die Dioden 72 bis 78 schalten die unterschiedlichen Strompfade in Abhängigkeit von der Verdrahtung bzw. dem Potential am Brückenanschluss 86, wobei diese Umschaltung automatisch erfolgt. Diese Variante der Erfindung beinhaltet somit eine automatische Erkennung der jeweils gewählten Verdrahtungsart.

Figur 4 zeigt eine weitere Variante, die eine automatische Erkennung der Verdrahtung ermöglicht. Gleiche Bezugszeichen bezeichnen wiederum dieselben Elemente wie zuvor. Die interne Verschaltung dieser Variante entspricht der in Figur 2 dargestellten Lösung mit den beiden Transistoren 90, 92. Wenn nun der Mikrocontroller 62 die beiden Transistoren 90, 92 wechselweise leitend und sperrend schaltet, wird der Brückenanschluss 88 wechselweise mit Betriebsspannung U_{B} oder Masse belegt. Wenn nun ein Meldekontakt 24b/24b' an den Brückenanschluss 86 angeschlossen wird, fließt ein Steuerstrom durch den Brückenzweig und über den Optokoppler 84, sobald die Brückenanschlüsse 86, 88 auf unterschiedlichem Potential liegen. Der Mikrocontroller 62 kann den Stromfluss mit Hilfe des Optokopplers 84 erkennen und er behält die dann vorliegende Schaltstellung der Transistoren 90, 92 bei.

Um zu verhindern, dass der Mikrocontroller 62 die "Suche" nach der gewählten Verdrahtung des Meldekontaktes 24b/24' sofort wieder beginnt, wenn der angeschlossene Meldekontakt geöffnet wird, ist die Freigabeeinheit 94 (Figur 2) vorgesehen. Diese ist in Form einer Selbsthaltung so ausgebildet, dass sie den Zugriff des Mikrocontrollers 62 auf die Transistoren 90, 92 unterbindet, sobald ein definiertes Potential am Brückenanschluss 86 und/oder ein Stromfluss im Brückenzweig erkannt wird. Die Freigabeeinheit 94 gibt den Zugriff des Mikrocontrollers 62 auf die Transistoren 90, 92 erst wieder frei, wenn das Sicherheitsschaltgerät 22 nach Wegfall der Betriebsspannung UB am Anschluss 46 erneut in Betrieb genommen wird.

In einem weiteren Ausführungsbeispiel (hier nicht dargestellt) kann das Potential an dem Brückenanschluss 88 manuell umgeschaltet werden, um wahlweise zwischen den alternativen Strompfaden des Brückengleichrichters umzuschalten.

## Patentansprüche

1. Sicherheitsschaltvorrichtung zum fehlersicheren Abschalten eines elektrischen Verbrauchers (26, 28), insbesondere in einer automatisiert betriebenen Anlage (10), mit einem ersten und einem zweiten Anschluss (36, 38) zum Zuführen eines ersten und eines zweiten Meldesignals, und mit einem ersten und einem zweiten Schaltelement (K1, K2), die zusammen dazu ausgebildet sind, ein redundantes Ausgangsschaltsignal zum Abschalten des Verbrauchers (26, 28) zu erzeugen, wobei das erste Schaltelement (K1) einen ersten Steuerkreis (56) aufweist, dem das erste Meldesignal zugeführt ist, und wobei das zweite Schaltelement (K2) einen zweiten Steuerkreis (58) aufweist, dem das zweite Meldesignal zugeführt ist,
**dadurch gekennzeichnet, dass** die Sicherheitsschaltvorrichtung ein Schaltnetzwerk mit einem ersten Strompfad (90, 74, 58, 84, 78), einem alternativen zweiten Strompfad (72, 58, 84, 76, 92) und zumindest einem weiteren Schaltelement (72-78, 90, 92) aufweist,
wobei das zweite Meldesignal unterschiedliche Polaritäten annehmen kann, und
wobei das zumindest eine weitere Schaltelement (72-78, 90, 92) dazu ausgebildet ist, in Abhängigkeit von der Polarität des zweiten Meldesignals entweder den ersten oder den zweiten Strompfad zu schließen, um das zweite Meldesignal zu dem zweiten Steuerkreis (58) zu führen, sodass in Abhängigkeit von der verwendeten Polarität eine Verdrahtung mit oder ohne Querschlusserkennung möglich ist.

2. Sicherheitsschaltvorrichtung nach Anspruch 1, **dadurch gekennzeichnet**, dassdie Sicherheitsschaltvorrichtung ferner dazu ausgebildet ist, das erste und das zweite Meldesignal bei einer Verdrahtung mit oder ohne Querschlusserkennung über gleiche Anschlussklemmen zu führen.

3. Sicherheitsschaltvorrichtung nach Anspruch 1 oder 2, **dadurch gekennzeichnet, dass** das Schaltnetzwerk eine Vielzahl von ersten weiteren Schaltelementen (72-78) beinhaltet, die einen Brückengleichrichter bilden.

4. Sicherheitsschaltvorrichtung nach Anspruch 3, **dadurch gekennzeichnet, dass** der Brückengleichrichter einen ersten und einen zweiten Brückenanschluss (80, 82) besitzt, zwischen denen der zweite Steuerkreis (58) angeordnet ist.

5. Sicherheitsschaltvorrichtung nach Anspruch 3 oder 4, **dadurch gekennzeichnet, dass** der Brückengleichrichter einen dritten und einen vierten Brückenanschluss (86, 88) besitzt, wobei der dritte Brückenanschluss (86) mit dem zweiten Anschluss (38) gekoppelt ist, und wobei der vierte Anschluss (88) mit einem definierten Referenzpotential belegt ist.

6. Sicherheitsschaltvorrichtung nach Anspruch 5, **dadurch gekennzeichnet, dass** das zweite Meldesignal zwischen einem hohen ersten (U_{B}) und einem niedrigen zweiten Signalpegel (Masse) wechselt, wobei das definierte Referenzpotential (U_{B}/2) etwa mittig zwischen dem ersten und zweiten Signalpegel liegt.

7. Sicherheitsschaltvorrichtung nach einem der Ansprüche 1 bis 6, **dadurch gekennzeichnet, dass** das Schaltnetzwerk zumindest ein zweites weiteres Schaltelement (90, 92) beinhaltet, das dazu ausgebildet ist, den zweiten Steuerkreis (58) wahlweise mit einem ersten oder einem zweiten Betriebspotential (UB, Masse) zu verbinden.

8. Sicherheitsschaltvorrichtung nach Anspruch 7, **gekennzeichnet durch** eine Steuereinheit (62), die dazu ausgebildet ist, den zweiten Steuerkreis (58) solange wechselweise mit dem ersten oder dem zweiten Betriebspotential (U_{B}, Masse) zu verbinden, bis ein Stromfluss im zweiten Steuerkreis (58) detektierbar ist.

9. Sicherheitsschaltvorrichtung nach Anspruch 8, **gekennzeichnet durch** eine Freigabeeinheit (94), die dazu ausgebildet ist, die Steuereinheit (62) zu blockieren, sobald ein Stromfluss im zweiten Steuerkreis (58) detektiert ist.

10. Sicherheitsschaltvorrichtung nach einem der Ansprüche 7 bis 9, **gekennzeichnet durch** ein Stellelement (96) mit zumindest zwei Stellpositionen, wobei das Stellelement mit dem zumindest einen zweiten weiteren Schaltelement (90, 92) gekoppelt ist, um den zweiten Steuerkreis (58) wahlweise mit dem ersten oder dem zweiten Betriebspotential (U_{B}, Masse) zu verbinden.

11. Sicherheitsschaltvorrichtung nach einem der Ansprüche 1 bis 10, **dadurch gekennzeichnet, dass** zumindest das zweite Schaltelement (K2) ein elektromechanisches Schaltelement ist.

## Claims

1. A safety switching apparatus for failsafe disconnection of an electrical load (26, 28), in particular in an automatically operated installation (10), comprising a first and a second terminal (36, 38) for supplying a first and a second signal, and comprising a first and a second switching element (K1, K2), which together are designed to produce a redundant output switching signal for disconnecting the load (26, 28), wherein the first switching element (K1) has a first control circuit (56) to which the first signal is supplied, and wherein the second switching element (K2) has a second control circuit (58) to which the second signal is supplied,
**characterized in that** the safety switching apparatus comprises circuitry having a first current path (90, 74, 58, 84, 78), an alternative second current path (72-58, 84, 76, 92) and at least one further switching element (72-78, 90, 92),
wherein the second signal can have different polarities, and
wherein the at least one further switching element (72-78, 90, 92) is designed to connect either the first or the second current path, depending the polarity of the second signal, in order to route the second signal to the second control circuit (58), such that, depending on the polarity used, wiring with or without short-circuit identification is possible.

2. The safety switching apparatus of claim 1, **characterized in that** the safety switching apparatus is further designed to route the first and the second signal via same connection terminals both for wiring with or without short-circuit identification.

3. The safety switching apparatus of claim 1 or 2, **characterized in that** the circuitry comprises a plurality of first further switching elements (72-78) which form a bridge rectifier.

4. The safety switching apparatus of claim 3, **characterized in that** the bridge rectifier has a first and a second bridge terminal (80, 82), the second control circuit (58) being arranged between them.

5. The safety switching apparatus of claim 3 or 4, **characterized in that** the bridge rectifier has a third and a fourth bridge terminal (86, 88), wherein the third bridge terminal (86) is coupled to the second terminal (38), and wherein the fourth terminal (88) is connected to a defined reference potential.

6. The safety switching apparatus of claim 5, **characterized in that** the second signal alternates between a high first signal level (U_{B}) and a low second signal level (ground), wherein the defined reference potential (U_{B}/2) is substantially in the mid between the first and second signal levels.

7. The safety switching apparatus of one of claims 1 to 6, **characterized in that** the circuitry comprises at least one second further switching element (90, 92) which is designed to connect the second control circuit (58) either to a first or to a second operating potential (U_{B}, ground).

8. The safety switching apparatus of claim 7, **characterized by** a control unit (62) which is designed to connect the second control circuit (58) alternately to the first or to the second operating potential (U_{B}, ground) until a flow of current is detected in the second control circuit (58).

9. The safety switching apparatus of claim 8, **characterized by** an enabling unit (94) which is designed to disable the control unit (62) as soon as a flow of current is detected in the second control circuit (58).

10. The safety switching apparatus of one of claims 7 to 9, **characterized by** a control element (96) having at least two control positions, wherein the control element is operationally coupled to the at least one second further switching element (90, 92) in order to connect the second control circuit (58) either to the first or to the second operating potential (U_{B}, ground).

11. The safety switching apparatus of one of claims 1 to 10, **characterized in that** at least the second switching element (K2) is an electromechanical switching element.

## Revendications

1. Dispositif de commutation de sécurité destinée à mettre hors circuit sans erreur un récepteur électrique (26, 28), notamment un équipement (10) à fonctionnement automatisé, comprenant une première et une deuxième borne (36, 38) servant à l'acheminement d'un premier et d'un deuxième signal de notification, et comprenant un premier et un deuxième élément de commutation (K1, K2) qui, ensemble, sont configurés pour générer un signal de commutation de sortie redondant destiné à la mise hors circuit du récepteur (26, 28), le premier élément de commutation (K1) possédant un premier circuit de commande (56), auquel est acheminé le premier signal de notification, et le deuxième élément de commutation (K2) possédant un deuxième circuit de commande (58), auquel est acheminé le deuxième signal de notification,
**caractérisé en ce que** le dispositif de commutation de sécurité possède un réseau de commutation doté d'un premier trajet de courant (90, 74, 58, 84, 78), d'un deuxième trajet de courant (72, 58, 84, 76, 92) alternatif et d'au moins un élément de commutation supplémentaire (72-78, 90, 92),
le deuxième signal de notification pouvant adopter différentes polarités, et
l'au moins un élément de commutation supplémentaire (72-78, 90, 92) étant configuré pour fermer soit le premier, soit le deuxième trajet de courant, en fonction de la polarité du deuxième signal de notification, pour guider le deuxième signal de notification vers le deuxième circuit de commande (58), de sorte qu'un câblage avec ou sans détection de court-circuit transversal soit possible en fonction de la polarité appliquée.

2. Dispositif de commutation de sécurité selon la revendication 1, **caractérisé en ce que** le dispositif de commutation de sécurité est en outre configuré pour, dans le cas d'un câblage avec ou sans détection de court-circuit transversal, faire passer le premier et le deuxième signal de notification par les mêmes bornes de raccordement.

3. Dispositif de commutation de sécurité selon la revendication 1 ou 2, **caractérisé en ce que** le réseau de commutation contient une pluralité de premiers éléments de commutation (72-78) supplémentaires qui forment un redresseur en pont.

4. Dispositif de commutation de sécurité selon la revendication 3, **caractérisé en ce que** le redresseur en pont possède une première et une deuxième borne de pont (80, 82) entre lesquelles est disposé le deuxième circuit de commande (58).

5. Dispositif de commutation de sécurité selon la revendication 3 ou 4, **caractérisé en ce que** le redresseur en pont possède une troisième et une quatrième borne de pont (86, 88), la troisième borne de pont (86) étant connectée à la deuxième borne (38) et un potentiel de référence défini étant appliqué à la quatrième borne (88).

6. Dispositif de commutation de sécurité selon la revendication 5, **caractérisé en ce que** le deuxième signal de notification varie entre un premier (U_{B}) niveau de signal élevé et un deuxième (Masse) niveau de signal faible, le potentiel de référence défini (U_{B}/2) se trouvant approximativement au centre entre le premier et le deuxième niveau de signal.

7. Dispositif de commutation de sécurité selon l'une des revendications 1 à 6, **caractérisé en ce que** le réseau de commutation contient au moins un deuxième élément de commutation (90, 92) supplémentaire qui est configuré pour relier le deuxième circuit de commande (58), au choix, à un premier ou un deuxième potentiel de service (U_{B}, Masse).

8. Dispositif de commutation de sécurité selon la revendication 7, **caractérisé par** une unité de commande (62) qui est configurée pour relier le deuxième circuit de commande (58) en alternance au premier ou au deuxième potentiel de service (U_{B}, Masse) jusqu'à ce qu'un flux de courant puisse être détecté dans le deuxième circuit de commande (58).

9. Dispositif de commutation de sécurité selon la revendication 8, **caractérisé par** une unité de libération (94) qui est configurée pour bloquer l'unité de commande (62) dès qu'un flux de courant est détecté dans le deuxième circuit de commande (58).

10. Dispositif de commutation de sécurité selon l'une des revendications 7 à 9, **caractérisé par** un élément de réglage (96) comprenant au moins deux positions de réglage, l'élément de réglage étant couplé avec l'au moins un deuxième élément de commutation (90, 92) supplémentaire en vue de relier le deuxième circuit de commande (58), au choix, au premier ou au deuxième potentiel de service (U_{B}, Masse).

11. Dispositif de commutation de sécurité selon l'une des revendications 1 à 10, **caractérisé en ce qu'**au moins le deuxième élément de commutation (K2) est un élément de commutation électromécanique.
